# EUROPEAN PATENT SPECIFICATION

(11) **EP 1 528 433 B1**
(45) Date of publication and mention of the grant of the patent: **06.03.2019**
(21) Application number: 04256585.3
(22) Date of filing: 26.10.2004
(51) Int. Cl.: G03F 7/20

(54) **Immersion lithographic apparatus and method of operating the same**
Lithographischer Immersionsapparat und Verfahren zum Betrieb davon
Appareil de lithographie par immersion et procédé d'utilisation correspondant

(30) Priority: 28.10.2003 EP 03256820
(43) Date of publication of application: 04.05.2005
(60) Divisional application: 10180248.6
(73) Proprietor: ASML Netherlands B.V., 5504 DR Veldhoven (NL)
(72) Inventor: Hoogendam, Christiaan Alexander, 5509 NC Veldhoven (NL); Streefkerk, Bob, 5038 PE Tilburg (NL); Mulkens, Johannes Catharinus Hubertus, 5581 AB Waalre (NL); Bijlaart, Erik Theodorus Maria, 5247 XM Rosmalen (NL); Kolesnychenko, Aleksey Yurievich, 5701 EE Helmond (NL); Loopstra, Erik Roelof, 5591 BA Heeze (NL); Mertens, J.J.S.M., 5525 BC Duizel (NL); Slaghekke, Bernardus Antonius, 5502 PB Veldhhoven (NL); Tinnemans, P.A.J., 5527 GR Hapert (NL); Van Santen, Helmar, 1018 BB Amsterdam (NL)
(74) Representative: Corcoran, Gregory Martin Mason

(56) References cited:
- EP-A- 0 605 103
- EP-A- 0 834 773
- EP-A- 1 420 302
- EP-A- 1 482 372
- EP-A- 1 494 079
- WO-A-99/49504
- WO-A-2004/055803
- WO-A-2005/015315
- PATENT ABSTRACTS OF JAPAN vol. 0124, no. 20 (E-679), 8 November 1988 (1988-11-08) -& JP 63 157419 A (TOSHIBA CORP), 30 June 1988 (1988-06-30)
- PATENT ABSTRACTS OF JAPAN vol. 2003, no. 12, 5 December 2003 (2003-12-05) -& JP 2003 297735 A (SEIKO EPSON CORP), 17 October 2003 (2003-10-17) -& US 2004/103950 A1 (IRIGUCHI CHIHARU) 3 June 2004 (2004-06-03)

## Description

### Field

The present invention relates to an immersion lithographic projection apparatus and a method for operating said apparatus.

### Background

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

It has been proposed to immerse the substrate in the lithographic projection apparatus in a liquid having a relatively high refractive index, e.g. water, so as to fill a space between the final element of the projection system and the substrate. The point of this is to enable imaging of smaller features since the exposure radiation will have a shorter wavelength in the liquid. (The effect of the liquid may also be regarded as increasing the effective NA of the system and also increasing the depth of focus.) Other immersion liquids have been proposed, including water with solid particles (e.g. quartz) suspended therein.

However, submersing the substrate or substrate and substrate table in a bath of liquid (see for example US 4,509,852). means that there is a large body of liquid that must be accelerated during a scanning exposure. This requires additional or more powerful motors and turbulence in the liquid may lead to undesirable and unpredictable effects.

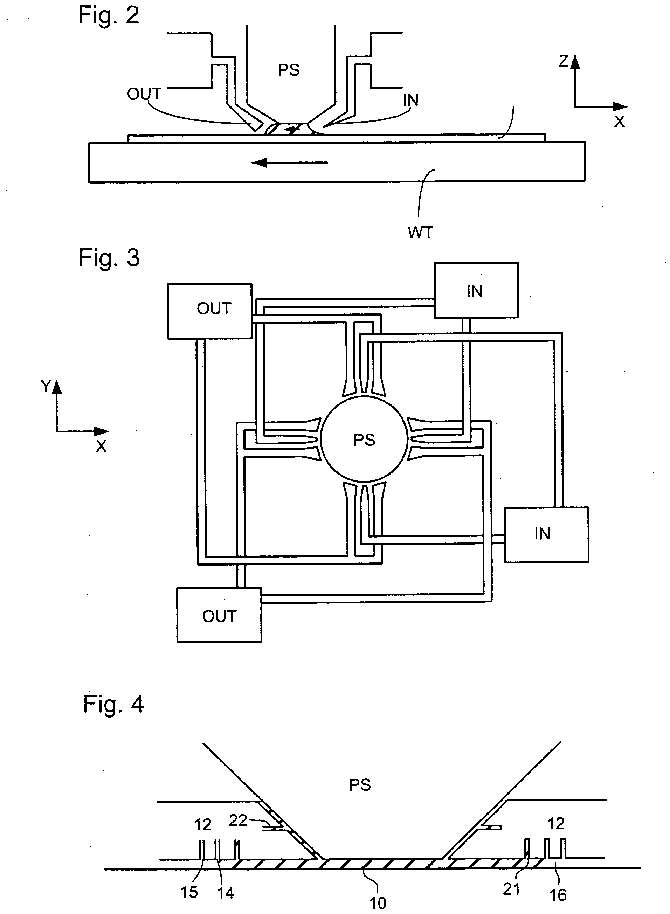

One of the solutions proposed is for a liquid supply system to provide liquid on only a localized area of the substrate and in between the final element of the projection system and the substrate using a liquid confinement system (the substrate generally has a larger surface area than the final element of the projection system). One way which has been proposed to arrange for this is disclosed in WO 99/49504. As illustrated in Figures 2 and 3, liquid is supplied by at least one inlet IN onto the substrate, preferably along the direction of movement of the substrate relative to the final element, and is removed by at least one outlet OUT after having passed under the projection system. That is, as the substrate is scanned beneath the element in a - X direction, liquid is supplied at the +X side of the element and taken up at the -X side. Figure 2 shows the arrangement schematically in which liquid is supplied via inlet IN and is taken up on the other side of the element by outlet OUT which is connected to a low pressure source. In the illustration of Figure 2 the liquid is supplied along the direction of movement of the substrate relative to the final element, though this does not need to be the case. Various orientations and numbers of in- and out-lets positioned around the final element are possible, one example is illustrated in Figure 3 in which four sets of an inlet with an outlet on either side are provided in a regular pattern around the final element.

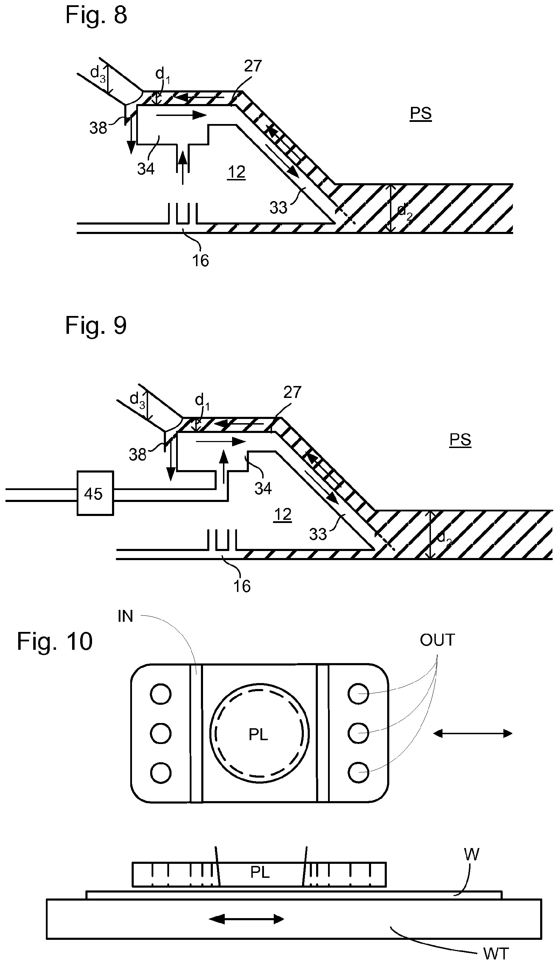

Another solution which has been proposed is to provide the liquid supply system with a seal member which extends along at least a part of a boundary of the space between the final element of the projection system and the substrate table. Such a solution is illustrated in Figure 10. The seal member is substantially stationary relative to the projection system in the XY plane though there may be some relative movement in the Z direction (in the direction of the optical axis). A seal is formed between the seal member and the surface of the substrate. Preferably the seal is a contactless seal such as a gas seal. Such as system with a gas seal is disclosed in European Patent Application No. 03252955.4.

In European Patent Application No. 03257072.3 the idea of a twin or dual stage immersion lithography apparatus is disclosed. Such an apparatus is provided with two stages for supporting the substrate. Leveling measurements are carried out with a stage at a first position, without immersion liquid, and exposure is carried out with a stage at a second position, where immersion liquid is present. Alternatively, the apparatus has only one stage.

However, if the liquid remains stationary, temperature fluctuations can cause wave front disturbances in the projection beam and thus cause errors in the projected image. It has therefore been proposed to refresh the liquid periodically. However, using the seal described above, or an outlet in the vicinity of the seal to remove the liquid causes mechanical vibrations thereby disturbing the exposure. Also, the pressure involved in liquid refreshment is high and the projection system is highly sensitive to pressure variations which can cause deformations in the final element of the projection system and disturbances. Consequently the depth of liquid around the projection system should be kept constant.

The motion of the substrate relative to the projection system can generate a pressure gradient. In some circumstances this can lead to the liquid being swept from underneath the projection system. Unless the liquid is uniform under the projection system, or if gas bubbles are present under the projection system the accuracy of the exposure will be compromised.

If an error occurs in the apparatus such as failure of the seal or the substrate table is accidentally removed from beneath the projection system the liquid will be dispersed throughout the apparatus potentially damaging the apparatus unless the liquid is removed quickly. The liquid supply systems proposed above, particularly the one including the gas seal do not provide a fast enough way of evacuating the liquid EP-A1-1420302 belongs to the prior art according to Article 54(3) EPC, and discloses an immersion lithographic apparatus comprising a transparent plate filled with liquid between the substrate table and the projection lens to prevent currents in the liquid from exerting forces on the projection lens. WO-A1-2004/055803 belongs to the prior art according to Article 54(3) EPC, and discloses an immersion lithographic apparatus wherein liquid is confined by a housing. EP-A1-1494079 also belongs to the prior art according to Article 54(3) EPC, and discloses an immersion lithographic apparatus wherein a liquid supply system comprises a seal member and provides a space between the final element of the projection system and the substrate with liquid. EP-A1-1482372 belongs to the prior art according to Article 54(3) EPC, and discloses an immersion lithographic apparatus wherein a reservoir is formed by a seal member such that liquid is confined to fill the space between the substrate surface and the final element of the projection system.

It is an object of the present invention to provide a system in which pressure fluctuations and/or temperature variations in the liquid are minimized without introducing unnecessary disturbances due to mechanical vibrations.

It is a further object of the invention to prevent sudden variations in the pressure of the liquid surrounding the final element of the projection system due to variations in the depth of the liquid.

These and other objects are achieved according to the invention in an immersion lithographic projection apparatus and a method as defined in the appended claims.

Thus the ridge should have an area such that as the volume of immersion liquid between the final element of the projection system and the substrate increases above the level of the ridge the depth of immersion liquid only increases very slowly. For simplicity the barrier is part of the liquid supply system.

In an embodiment of the invention, there is an overflow from the liquid reservoir formed by the immersion liquid and the excess liquid is removed to another location. The overflow can be used to maintain the liquid depth at a substantially constant level, thereby reducing pressure variations on the final element of the projection system due to a variable depth of liquid. As the fluid is being removed by an outlet other than that used in or around a gas seal mechanical vibrations will be reduced. Due to the presence of the overflow, liquid may be supplied at a higher flow rate than in conventional systems. The higher rate of liquid replacement ensures that the liquid doesn't heat up too much and also prevents contamination of the immersion liquid by the photoresist. According to an embodiment the overflow is the outlet liquid supply system. The apparatus further comprises an inlet for supplying liquid to the space between the final element of the projection system and the substrate, the overflow being arranged above the inlet to ensure the overflow effectively removes the liquid. The liquid is bounded by a barrier and an entrance to the overflow is positioned on the opposite side of the barrier. Thus only when the liquid is outside the boundary of the barrier is it removed by the overflow. The overflow is preferably arranged such that said liquid only flows into said overflow when said liquid flows over the top of said barrier. The overflow can be arranged so that it is at the same height as the top of the barrier or below the height of the barrier. For example, the barrier forms a ridge, the area of the ridge being not insignificant compared to the area of the final element of the projection system. For simplicity the barrier forms part of the liquid supply system. The liquid supply system referred to in this description is not limited simply to apparatus to supply fluid and can include elements to control the position, quantity, shape, flow rate or any other features of the fluid. The fluid continuously refreshed at a constant rate in order to reduce temperature variations.

In order to maintain the pressure above the liquid at a known level the space above the liquid is sealed with an airtight member. Furthermore the outlet can maintain the air pressure above the fluid at a constant level by, for example, providing a known suction force. Maintaining the gas pressure above the liquid at a constant level reduces the pressure variations on the projection system.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (e.g. with a wavelength of 365, 248, 193, 157 or 126 nm).

### BRIEF DESCRIPTION OF THE DRAWINGS

Embodiments, including embodiments of the invention, will now be described, by way of example only, with reference to the accompanying schematic drawings in which corresponding reference symbols indicate corresponding parts, and in which:
Figure 1 depicts a lithographic apparatus according to an embodiment;
Figures 2 and 3 depict a liquid supply system used in a prior art lithographic projection apparatus;
Figure 4 is a detail of a lithographic projection apparatus;
Figure 5 is a detail of a lithographic projection apparatus according to another embodiment showing an overflow;
Figure 6 is a detail of an alternative lithographic projection apparatus according to an embodiment;
Figure 7 is a detail of an alternative lithographic projection apparatus according to an embodiment;
Figure 8 is a detail of an alternative lithographic projection apparatus according to an embodiment;
Figure 9 is a detail of an embodiment; and
Figure 10 depicts a liquid supply system according to another prior art lithographic projection apparatus.

In the Figures, corresponding reference symbols indicate corresponding parts.

### DETAILED DESCRIPTION

### Embodiment 1

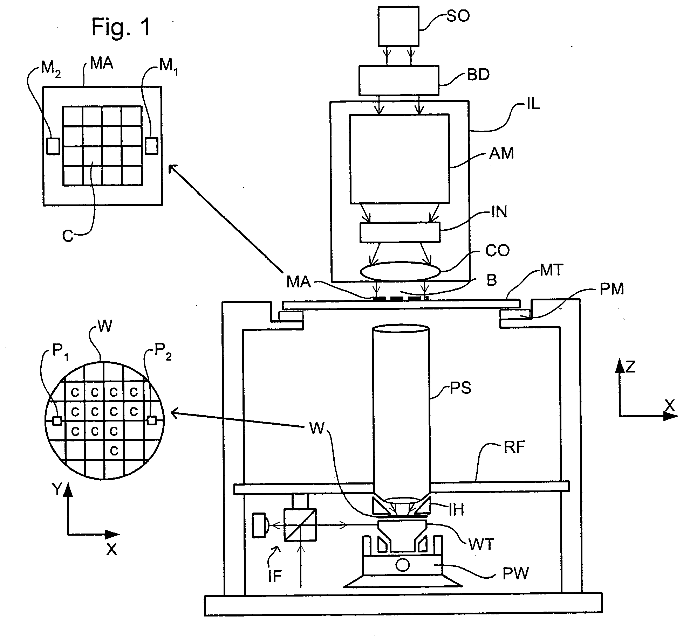

Figure 1 schematically depicts a lithographic apparatus according to one embodiment of the invention. The apparatus comprises:
- an illumination system (illuminator) IL configured to condition a radiation beam B (e.g. UV radiation or DUV radiation).
- a support structure (e.g. a mask table) MT constructed to support a patterning device (e.g. a mask) MA and connected to a first positioner PM configured to accurately position the patterning device in accordance with certain parameters;
- a substrate table (e.g. a wafer table) WT constructed to hold a substrate (e.g. a resist-coated wafer) W and connected to a second positioner PW configured to accurately position the substrate in accordance with certain parameters; and
- a projection system (e.g. a refractive projection lens system) PS configured to project a pattern imparted to the radiation beam B by patterning device MA onto a target portion C (e.g. comprising one or more dies) of the substrate W.

The illumination system may include various types of optical components, such as refractive, reflective, magnetic, electromagnetic, electrostatic or other types of optical components, or any combination thereof, for directing, shaping, or controlling radiation.

The support structure supports, i.e. bears the weight of, the patterning device. It holds the patterning device in a manner that depends on the orientation of the patterning device, the design of the lithographic apparatus, and other conditions, such as for example whether or not the patterning device is held in a vacuum environment. The support structure can use mechanical, vacuum, electrostatic or other clamping techniques to hold the patterning device. The support structure may be a frame or a table, for example, which may be fixed or movable as required. The support structure may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam which is reflected by the mirror matrix.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

As here depicted, the apparatus is of a transmissive type (e.g. employing a transmissive mask). Alternatively, the apparatus may be of a reflective type (e.g. employing a programmable mirror array of a type as referred to above, or employing a reflective mask).

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

Referring to Figure 1, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may comprise an adjuster AD for adjusting the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may comprise various other components, such as an integrator IN and a condenser CO. The illuminator may be used to condition the radiation beam, to have a desired uniformity and intensity distribution in its cross-section.

The radiation beam B is incident on the patterning device (e.g., mask MA), which is held on the support structure (e.g., mask table MT), and is patterned by the patterning device. Having traversed the mask MA, the radiation beam B passes through the projection system PS, which focuses the beam onto a target portion C of the substrate W. With the aid of the second positioner PW and position sensor IF (e.g. an interferometric device, linear encoder or capacitive sensor), the substrate table WT can be moved accurately, e.g. so as to position different target portions C in the path of the radiation beam B. Similarly, the first positioner PM and another position sensor (which is not explicitly depicted in Figure 1) can be used to accurately position the mask MA with respect to the path of the radiation beam B, e.g. after mechanical retrieval from a mask library, or during a scan. In general, movement of the mask table MT may be realized with the aid of a long-stroke module (coarse positioning) and a short-stroke module (fine positioning), which form part of the first positioner PM. Similarly, movement of the substrate table WT may be realized using a long-stroke module and a short-stroke module, which form part of the second positioner PW. In the case of a stepper (as opposed to a scanner) the mask table MT may be connected to a short-stroke actuator only, or may be fixed. Mask MA and substrate W may be aligned using mask alignment marks M1, M2 and substrate alignment marks PI, P2. Although the substrate alignment marks as illustrated occupy dedicated target portions, they may be located in spaces between target portions (these are known as scribe-lane alignment marks). Similarly, in situations in which more than one die is provided on the mask MA, the mask alignment marks may be located between the dies.

The depicted apparatus could be used in at least one of the following modes:
1. In step mode, the mask table MT and the substrate table WT are kept essentially stationary, while an entire pattern imparted to the radiation beam is projected onto a target portion C at one time (i.e. a single static exposure). The substrate table WT is then shifted in the X and/or Y direction so that a different target portion C can be exposed. In step mode, the maximum size of the exposure field limits the size of the target portion C imaged in a single static exposure.
2. In scan mode, the mask table MT and the substrate table WT are scanned synchronously while a pattern imparted to the radiation beam is projected onto a target portion C (i.e. a single dynamic exposure). The velocity and direction of the substrate table WT relative to the mask table MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion.
3. In another mode, the mask table MT is kept essentially stationary holding a programmable patterning device, and the substrate table WT is moved or scanned while a pattern imparted to the radiation beam is projected onto a target portion C. In this mode, generally a pulsed radiation source is employed and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above.

Combinations and/or variations on the above described modes of use or entirely different modes of use may also be employed.

As shown in Figure 4 a liquid reservoir 10 between the projection lens and the substrate is bounded by a gas seal 16 forming an annulus around the projection lens. The seal, preferably a gas seal is formed by gas, e.g. air or synthetic air but preferably N₂ or another inert gas, provided under pressure via inlet 15 to the gap between seal member 12 and substrate and extracted via first outlet 14. The overpressure on the gas inlet 15, vacuum level on the first outlet 14 and geometry of the gap are arranged so that there is a high-velocity air flow inwards that confines the liquid. The distance between the gas inlet and outlet and the substrate W is small.

The liquid reservoir is supplied with liquid by inlets 21 and 22 and excess liquid is removed via outlet 14. The liquid reservoir extends above the bottom of the final element of the projection system PS to the level where the seal member 12 bounding the liquid reservoir and forming a barrier suddenly widens as shown in Figure 4. The top of the seal member forms a ridge, the area of which is of an area similar to or larger than the area of the bottom of the final element of the projection system PL. Therefore, if the quantity of liquid in the reservoir increases dramatically the depth of the reservoir 10 will not increase significantly as a large increase in the volume of immersion liquid over the large area of the top of the seal member 12 will not generate a large change in the depth of immersion fluid. The pressure variations due to a change in the depth of the reservoir will therefore be minimal.

### Embodiment 2

Shows an alternative arrangement for the structure described in embodiment 1. An overflow structure 25 collects any excess liquid. The increase in depth of the liquid reservoir 10 due to an increase in the quantity of liquid is likely to be very small as a large amount of excess liquid can be accommodated in overflow structure 25. There is an annular shaped dyke 27 forming a barrier bounding the fluid and as the amount of liquid increases it flows over dyke 27 and into channel 26 which is an outlet, removing liquid from the reservoir 10. In this example the majority of the liquid is removed via channel 26 rather than outlet 14. The depth of fluid is thus controlled by the height of the dyke 27. As large amounts of liquid are not being removed via outlet 14 fewer vibrations are induced in the seal member 12 and the gas seal 16 functions more effectively. The flow rate of channel 26 should be sufficiently low to ensure that the gas content is small. Channel 26 is arranged above inlets 21 and 22 so the fluid overflows into channel 26.

### Embodiment 3

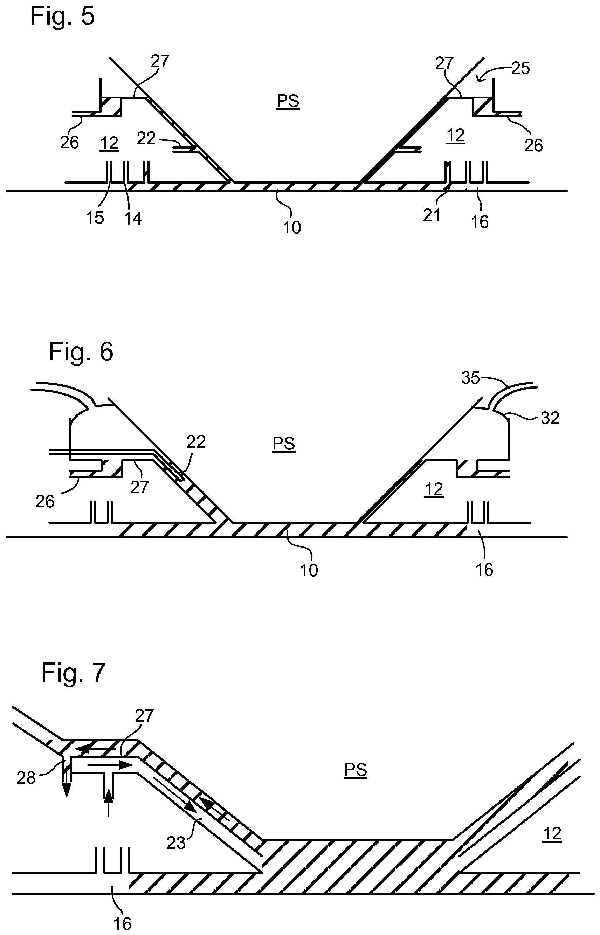

The embodiment shown in Figure 6 is the same as the embodiments above except for the aspects described below. There is just one inlet 22, separate from the seal member 12. Inlet 22 is formed between the projection system PS and the seal member 12 and fluid flows out from the inlet 22 at a height below that of the dyke 27, but above that of the bottom of the final element of the projection system PS. Fluid is supplied at a constant rate R, but, similarly to embodiment 2, the fluid is predominantly removed via channel 26 rather than gas outlet 14. The rate of substance removal through channel 26 is also a constant rate R. Seal 32 confines the gas around the reservoir 10 and prevents the moisture laden gas from pervading the whole apparatus, thereby damaging delicate parts and compromising the accuracy of measurements, e.g. interferometer readings. To keep the gas pressure above the reservoir 10 constant, and therefore the pressure at the final element of the projection system PS constant there is a passage 35 through the seal 32 through which gas can flow. The passage 35 leads outside the apparatus, thereby removing moisture laden air. The passage 35 should preferably have a low resistance allowing the gas to flow freely.

### Embodiment 4

In this embodiment fluid is supplied through concentric ring (i.e. annular) shaped inlet 23 arranged on the inner circumference of seal member 12 shown in Figure 7. Inlet 23 has a slit width of approximately 20 µm to 300 µm, preferably 150µm, is arranged at a distance of approximately 0.5mm from the substrate W and directs a channel of fluid towards the area directly under the projection system PS (i.e. the target portion) such that the fluid directly under the projection system PS is constantly refreshed. In this example the inlet 23 forms the inner edge of the seal member 12, but it could also be arranged so it was just adjacent to the inner circumference of the seal member 12. Alternatively inlet 23 could be a plurality of pipes arranged on the inner circumference of the seal member 12. As shown in figure 7 a passage is formed between elements of the projection system PS and the seal member 12. Having circulated under the final element of the projection system PS the fluid flows through this passage and over the dyke 27 prior to being removed via outlet 28. However, unlike the earlier embodiments elements of the projection system PS, another part of the apparatus bounds the upper level of the reservoir 10. No surface waves can therefore occur and static hydraulic pressures are limited resulting in a continuous uniform pressure on the projection system PS.

### Embodiment 5

The embodiment is the same as embodiment 4 except for the aspects described below. Inlet 33 is annular shaped with a diameter of approximately 50-100mm and a width of 20µm to 300µm, preferably 150µm. As shown in Figure 8 the inlet 33 can end before the bottom of the seal member 12 or can extend to the bottom of the seal member 12 or anywhere in between. Immersion liquid is supplied to inlet 33 through chamber 34 which has a greater cross-sectional area than inlet 33 to ensure that the chamber 34 provides a smaller restriction to flow.

In this embodiment the seal member 12 and the projection system PS are arranged such that the immersion fluid is held between the seal member 12 and the projection system PL by capillary forces at the level of dyke 27.

The edges of seal member 12 slope towards the projection system PS with an angle to the direction of propagation of the radiation beam B of approximately 45°. Dyke 27 intersects this slope and forms a broad ridge substantially perpendicular to the direction of propagation of the radiation beam B. The edges of projection system PS form a complimentary shape to the seal member 12 having a slope to the direction of propagation of the projection beam B of approximately 45° and also having a broad area perpendicular to the direction of propagation of the radiation beam B radially outwardly of the slope.

Outlet 38 is arranged beyond dyke 27 and has a greater flow rate than the rate of flow through inlet 33 to make sure that the amount of immersion fluid in reservoir 10 is controlled. Consequently some gas is also removed through outlet 38. Distance d₃ is governed by the actuation height of the seal member 12 and in this example is at least 2 mm. Distance d₃ should however be as large as possible to ensure that there is sufficient air flow for outlet 38. This arrangement of apparatus ensures that the depth of immersion fluid remains constant at the level of the projection system PS just above dyke 27.

To prevent the final element of the projection system PS from damage the distance d₁ between dyke 27 and the projection system PS is 2mm whereas the distance d₂ between the final element of the projection system PS and the substrate is greater than 2mm.

### Embodiment 6

In this embodiment the flow of fluid through the inlet 33 is controlled by valve 45 shown in Figure 9. During ordinary operation of the apparatus valve 45 allows fluid to flow freely through inlet 33. However, when an error is detected in the system or apparatus, for example accidental removal of the substrate W and substrate table WT or a servo error, valve 45 automatically connects inlet 33 to a high vacuum chamber (not shown in the accompanying drawings). The liquid can therefore be quickly removed from the reservoir. The valve 45 and associated vacuum chamber can be connected to other inlets e.g. inlets 21 and 23 shown in embodiments 4 to 7.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat-panel displays, liquid-crystal displays (LCDs), thin-film magnetic heads, etc. The skilled artisan will appreciate that, in the context of such alternative applications, any use of the terms "reticle", "wafer" or "die" herein may be considered as synonymous with the more general terms "mask", "substrate" or "target portion", respectively. The substrate referred to herein may be processed, before or after exposure, in for example a track (a tool that typically applies a layer of resist to a substrate and develops the exposed resist) a metrology tool and/or an inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The terms "radiation" and "beam" used herein encompass all types of electromagnetic radiation, including ultraviolet (UV) radiation (e.g. having a wavelength of or about 365, 248, 193, 157 or 126 nm) and extreme ultra-violet (EUV) radiation (e.g. having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

The present invention can be applied to any immersion lithography apparatus, in particular, but not exclusively, those types mentioned above.

The descriptions above are intended to be illustrative, not limiting. Thus, it will be apparent to one skilled in the art that modifications may be made to the invention as described without departing from the scope of the claims set out below. The invention is defined by the claims.

## Claims

1. An immersion lithographic projection apparatus comprising:
a substrate table (WT) arranged to hold a substrate (W);
a projection system (PS) arranged to project a patterned beam onto a target portion of the substrate (W);
a liquid supply system arranged to at least partly fill a space between the final element of said projection system (PS) and said substrate (W) with a liquid to form a liquid reservoir (10); a liquid confinement system arranged such that the liquid supply system provides liquid to form the liquid reservoir (10) on only a localized area of the substrate (W); a barrier (27) and an overflow (25) from said liquid reservoir (10), wherein the barrier is arranged to bound the liquid, and
wherein the overflow is arranged so that the entrance of said overflow is positioned on the opposite side of the barrier and so that liquid only flows into the overflow (25) when the liquid flows over the top of said barrier (27).

2. The immersion lithographic projection apparatus according to claim 1 further comprising an inlet (21, 22, 23) for supplying liquid to said space, wherein said overflow (25) is arranged above said inlet (21, 22).

3. The immersion lithographic projection apparatus according to claim 1 or 2, wherein said barrier (27) forms part of the liquid supply system.

4. The immersion lithographic projection apparatus according to claim 1, 2 or 3, wherein said barrier (27) is arranged to form a ridge having an area which is not insignificant compared to the area of the final element of the projection system.

5. The immersion lithographic projection apparatus according to any one of the preceding claims, wherein the liquid confinement system comprises a seal member (12) extending along at least a part of the boundary of said space between the final element of said projection system (PS) and said substrate table (WT), said seal member (12) and said projection system (PS) forming a capillary passage, said overflow (25) being arranged to remove liquid at the end of at least part of said capillary passage.

6. The immersion lithographic projection apparatus according to any one of the preceding claims, wherein the liquid confinement system comprises a seal member (12) extending along at least a part of the boundary of said space between the final element of said projection system (PS) and said substrate table (WT) and an inlet (23, 33) for supplying liquid to said space, said inlet (23) being adjacent to the inner circumference of said seal member (12) and directed towards the target portion of said substrate (W).

7. A method of operating the immersion lithographic projection apparatus of any one of claims 1-6.

## Patentansprüche

1. Ein immersionslithographisches Projektionsgerät, das Folgendes beinhaltet:
einen Substrattisch (WT), der eingerichtet ist, um ein Substrat (W) zu halten;
ein Projektionssystem (PS), das eingerichtet ist, um einen gemusterten Strahl auf einen Zielabschnitt des Substrats (W) zu projizieren;
ein Flüssigkeitszufuhrsystem, das eingerichtet ist, um einen Raum zwischen der Endkomponente des Projektionssystems (PS) und dem Substrat (W) mindestens teilweise mit einer Flüssigkeit zu füllen, um ein Flüssigkeitsreservoir (10) zu bilden;
ein Flüssigkeitseingrenzungssystem, das so eingerichtet ist, dass das Flüssigkeitszufuhrsystem Flüssigkeit zum Bilden des Flüssigkeitsreservoirs (10) auf nur einer örtlich begrenzten Fläche des Substrats (W) bereitstellt;
eine Barriere (27) und einen Überlauf (25) aus dem Flüssigkeitsreservoir (10), wobei die Barriere eingerichtet ist, um die Flüssigkeit zu begrenzen, und wobei der Überlauf so eingerichtet ist, dass der Eingang des Überlaufs auf der entgegengesetzten Seite der Barriere positioniert ist und dass Flüssigkeit nur dann in den Überlauf (25) fließt, wenn die Flüssigkeit über die Oberseite der Barriere (27) fließt.

2. Immersionslithographisches Projektionsgerät gemäß Anspruch 1, das ferner einen Einlass (21, 22, 23) beinhaltet, um dem Raum Flüssigkeit zuzuführen, wobei der Überlauf (25) über dem Einlass (21, 22) eingerichtet ist.

3. Immersionslithographisches Projektionsgerät gemäß Anspruch 1 oder 2, wobei die Barriere (27) einen Teil des Flüssigkeitszufuhrsystems bildet.

4. Immersionslithographisches Projektionsgerät gemäß Anspruch 1, 2 oder 3, wobei die Barriere (27) eingerichtet ist, um einen Rücken mit einer Fläche zu bilden, die im Vergleich zu der Fläche der Endkomponente des Projektionssystems nicht insignifikant ist.

5. Immersionslithographisches Projektionsgerät gemäß einem der vorhergehenden Ansprüche, wobei das Flüssigkeitseingrenzungssystem ein Abdichtungselement (12) beinhaltet, das sich entlang mindestens einem Teil der Grenze des Raums zwischen der Endkomponente des Projektionssystems (PS) und dem Substrattisch (WT) erstreckt, wobei das Abdichtungselement (12) und das Projektionssystem (PS) einen Kapillardurchgang bilden, wobei der Überlauf (25) eingerichtet ist, um Flüssigkeit an dem Ende von mindestens einem Teil des Kapillardurchgangs zu entfernen.

6. Immersionslithographisches Projektionsgerät gemäß einem der vorhergehenden Ansprüche, wobei das Flüssigkeitseingrenzungssystem ein Abdichtungselement (12), das sich entlang mindestens einem Teil der Grenze des Raums zwischen der Endkomponente des Projektionssystems (PS) und dem Substrattisch (WT) erstreckt, und einen Einlass (23, 33) zum Zuführen von Flüssigkeit in den Raum beinhaltet, wobei sich der Einlass (23) neben dem inneren Umfang des Abdichtungselements (12) befindet und in Richtung des Zielabschnitts des Substrats (W) gerichtet ist.

7. Ein Verfahren zum Betreiben des immersionslithographischen Projektionsgeräts gemäß einem der Ansprüche 1-6.

## Revendications

1. Un appareil de projection lithographique à immersion comprenant :
une table porte-substrat (WT) agencée pour porter un substrat (W) ;
un système de projection (PS) agencé pour projeter un faisceau à motif sur une portion cible du substrat (W) ;
un système d'alimentation en liquide agencé pour remplir au moins en partie un espace entre l'élément final dudit système de projection (PS) et ledit substrat (W) avec un liquide afin de former un réservoir de liquide (10) ;
un système de confinement de liquide agencé de telle sorte que le système d'alimentation en liquide fournit du liquide afin de former le réservoir de liquide (10) uniquement sur une aire localisée du substrat (W) ;
une barrière (27) et un trop-plein (25) depuis ledit réservoir de liquide (10), où la barrière est agencée afin de retenir le liquide, et où le trop-plein est agencé de sorte que l'entrée dudit trop-plein est positionnée sur le côté opposé de la barrière et de sorte qu'il s'écoule du liquide dans le trop-plein (25) uniquement lorsque le liquide passe pardessus la face supérieure de ladite barrière (27).

2. L'appareil de projection lithographique à immersion selon la revendication 1 comprenant en sus une arrivée (21, 22, 23) pour alimenter en liquide ledit espace, où ledit trop-plein (25) est agencé au-dessus de ladite arrivée (21, 22).

3. L'appareil de projection lithographique à immersion selon la revendication 1 ou la revendication 2, où ladite barrière (27) fait partie du système d'alimentation en liquide.

4. L'appareil de projection lithographique à immersion selon la revendication 1, la revendication 2 ou la revendication 3, où ladite barrière (27) est agencée afin de former une arête ayant une aire qui n'est pas insignifiante comparée à l'aire de l'élément final du système de projection.

5. L'appareil de projection lithographique à immersion selon l'une quelconque des revendications précédentes, où le système de confinement de liquide comprend un élément d'étanchéité (12) s'étendant le long d'au moins une partie de la délimitation dudit espace entre l'élément final dudit système de projection (PS) et ladite table porte-substrat (WT), ledit élément d'étanchéité (12) et ledit système de projection (PS) formant un passage capillaire, ledit trop-plein (25) étant agencé afin de retirer du liquide au niveau de l'extrémité d'au moins une partie dudit passage capillaire.

6. L'appareil de projection lithographique à immersion selon l'une quelconque des revendications précédentes, où le système de confinement de liquide comprend un élément d'étanchéité (12) s'étendant le long d'au moins une partie de la délimitation dudit espace entre l'élément final dudit système de projection (PS) et ladite table porte-substrat (WT) et une arrivée (23, 33) pour alimenter en liquide ledit espace, ladite arrivée (23) étant adjacente à la circonférence interne dudit élément d'étanchéité (12) et dirigée vers la portion cible dudit substrat (W).

7. Un procédé pour faire fonctionner l'appareil de projection lithographique à immersion de l'une quelconque des revendications 1 à 6.
